(19)

Europäisches
Patentamt
European
Patent Office
Office européen
des brevets

(11) **EP 4 783 066 A1**

(12) **EUROPEAN PATENT APPLICATION**

(43) Date of publication:
**29.07.2026 Bulletin 2026/31**

(21) Application number: **25203655.3**

(22) Date of filing: **22.09.2025**

(51) International Patent Classification (IPC):
**G06N 3/044** (2023.01)    **G06N 3/048** (2023.01)
**G06N 3/065** (2023.01)    **G11C 13/00** (2006.01)
**G06F 9/50** (2006.01)

(52) Cooperative Patent Classification (CPC):
**G06N 3/044; G06F 9/5044; G06F 9/5066;
G06N 3/048; G06N 3/065; G11C 11/54;
G11C 13/0002**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **28.01.2025 IN 202521006987**

(71) Applicant: **Tata Consultancy Services Limited
Maharashtra (IN)**

(72) Inventors:
• **DEY, Sounak
700160 Kolkata (IN)**

• **BANERJEE, Dighanchal
700160 Kolkata (IN)**
• **MUKHERJEE, Arijit
700160 Kolkata (IN)**
• **PAL, Arpan
700160 Kolkata (IN)**
• **SURI, Manan
110016 New Delhi (IN)**
• **MOORTHII JAYAPRAKASH, Chithambara
110016 New Delhi (IN)**

(74) Representative: **Goddar, Heinz J.
Boehmert & Boehmert
Anwaltspartnerschaft mbB
Pettenkoferstrasse 22
80336 München (DE)**

(54) **RESISTIVE RANDOM-ACCESS MEMORY (RRAM) BASED IN-MEMORY COMPUTING FOR
EFFICIENT IMPLEMENTATION OF GATED RECURRENT UNITS**

(57)    The present disclosure addresses energy overheads and latency challenges of architecture design of conventional gated recurrent unit (GRU) approaches by providing a Resistive Random-Access Memory In-Memory Computing-based gated recurrent unit (RRAM IMC-based GRU) network architecture for efficient implementation of GRUs. In the present disclosure, the RRAM IMC-based GRU network architecture is used which performs Multiply-Accumulate (MAC) operations using Ohm's law for multiplication and Kirchhoff's current law for accumulation. A plurality of GRU wight parameters are mapped as device conductance in a Resistive Random-Access Memory (RRAM) memristor array structure in a skewed arrangement. An input vector is applied as voltage pulses to wordlines of the RRAM memristor array structure corresponding to values which should be multiplied and accumulated. Outputs of the MAC operation are obtained as bitline currents, which are then sampled and converted to digital values using an Analog-to-Digital Converters for interfacing with other digital post-processing units.

Mapping a specific GRU weight network parameter from a plurality of GRU weight network parameter to each of a memristor array structure of a Resistive Random-Access Memory In-Memory Computing-based gated recurrent unit (RRAM IMC-based GRU) network architecture in a skewed arrangement for being stored, wherein the RRAM IMC-based GRU network architecture comprises a first storage unit, a second storage unit, an In Memory Computing (IMC) controller unit, and a reduced instruction set computing (RISC-V) based core processing unit, wherein the second storge unit comprises a plurality of modules that includes a first set of IMC circuit modules, a second set of IMC circuit modules, an output specific IMC circuit module, an adder circuit module, and one or more biasing circuit modules, and wherein each IMC circuit module in the first set of IMC circuit modules and the second set of IMC circuit modules comprise a plurality of RRAM devices that are arranged as a plurality of memristor array structures, wherein each memristor array structure from the plurality of memristor array structures comprises a plurality of rows and a plurality of columns connected by a plurality of memristive cells, and wherein each GRU weight network parameter represents a — 202

↓

Inputting a multi-bit input vector to a plurality of rows of a first memristor array structure of the first set of IMC circuit modules that is mapped to a specific GRU weight network parameter and a past hidden state vector to the plurality of rows of a first memristor array structure of the second set of IMC circuit modules that is mapped to the corresponding specific GRU weight network parameter, wherein the multi-bit input vector and the past hidden state vector represent a voltage value — 204

↓

(A)

**FIG. 2A**

EP 4 783 066 A1

**Description**

CROSS-REFERENCE TO RELATED APPLICATIONS AND PRIORITY

The present application claims priority from Indian provisional patent application no. 202521006987, filed on January 28, 2025.

TECHNICAL FIELD

The disclosure herein generally relates to the field of gated recurrent units, and, more particularly, to Resistive Random-Access Memory (RRAM) based In-Memory Computing for efficient implementation of gated recurrent units.

BACKGROUND

Recurrent neural networks (RNNs) are a type of artificial neural network which are used for time series data, natural language processing, and speech recognition applications. In contrast to traditional neural networks, RNNs handle sequential data utilizing a memory concept, and allowing networks to retain previous input information. However, a drawback of RNNs is their limited short-term memory due to a vanishing gradient problem, which hampers their capacity to retain information across long sequences. Therefore, more advanced variants of RNNs such as long-short term memory (LSTM) and gated recurrent unit (GRU) are designed to address short-term memory issues. However, LSTMs are more complex and computationally demanding than RNNs and GRUs, which makes training process more challenging. Unlike LSTM, a GRU has a simpler structure with fewer parameters, yet it achieves comparable accuracy performance and can even outperform LSTM in certain applications.

In GRUs, operations that typically consume most time and energy are matrix multiplications involved in calculating gates and candidate hidden states. These operations are computationally intensive and are repeated for each time step in a sequence. On central processing units (CPUs), matrix multiplications can be quite slow due to their general-purpose nature and lack of specialized hardware for parallel processing of such operations. Graphics Processing Units (GPUs) handle matrix multiplications more efficiently due to their architecture optimized for parallel processing, but they still consume a significant amount of energy. Field-programmable gate array (FPGA) implementations can be optimized to handle matrix multiplications more efficiently in terms of energy and time but achieving this requires sophisticated hardware design.

There exists a work that has shown implementation of GRU architecture on FPGA, which shows significant improvement in performance compared to software implementations on GPUs. However, it is difficult to achieve efficient training on FPGA implementation of GRU due to limited storage and bandwidth. Further few other conventional systems have shown implementation of GRU on a memristor based- GRU network for denoising autoencoder and SOC estimation of Lithium-ion battery. Nevertheless, architecture of the conventional systems includes implementation of all GRU operations in analog circuits, however, the implementations show input and weight parameters of single-bit precision. Thus, traditional GRU implementation based on von Neumann architectures, although proficient in managing sequential data for machine learning tasks, commonly face considerable energy overheads and latency challenges caused by frequent data transfers between memory and processing units.

SUMMARY

Embodiments of the present disclosure present technological improvements as solutions to one or more of the above-mentioned technical problems recognized by the inventors in conventional systems. For example, in one embodiment, a processor implemented method is provided. The processor implemented method, comprising: mapping, via one or more hardware processors, a specific GRU weight network parameter from a plurality of GRU weight network parameter to each of a memristor array structure of a Resistive Random-Access Memory In-Memory Computing-based gated recurrent unit (RRAM IMC-based GRU) network architecture in a skewed arrangement for being stored, wherein the RRAM IMC-based GRU network architecture comprises a first storage unit, a second storage unit, an In Memory Computing (IMC) controller unit, and a reduced instruction set computing (RISC-V) based core processing unit, wherein the second storge unit comprises a plurality of modules that includes a first set of IMC circuit modules, a second set of IMC circuit modules, an output specific IMC circuit module, an adder circuit module, and one or more biasing circuit modules, and wherein each IMC circuit module in the first set of IMC circuit modules and the second set of IMC circuit modules comprise a plurality of RRAM devices that are arranged as a plurality of memristor array structures, wherein each memristor array structure from the plurality of memristor array structures comprises a plurality of rows and a plurality of columns connected by a plurality of memristive cells, and wherein each GRU weight network parameter represents a conductance value; inputting, via the one or more hardware processors, a multi-bit input vector to a plurality of rows of a first memristor array structure of the first set of IMC circuit modules that is mapped to a specific GRU weight network parameter and a past hidden state vector to the plurality of rows of a first memristor array structure of the second set of IMC circuit modules that is mapped to the corresponding specific GRU weight network parameter, wherein the multi-bit input vector and the past hidden state vector represent a voltage value; concurrently performing, via the one or more hardware processors, a plurality of GRU operations on the RRAM IMC-based GRU network architecture using the multi-bit input vector, the plurality GRU weight network parameters, and the past hidden state vector for obtaining a plurality of IMC output values, wherein the plurality of GRU operations are concurrently performed till an end of the multi-bit input vector application and a last value of the past hidden state vector is applied to the RRAM IMC-based GRU network architecture, and wherein the plurality of GRU operations comprise at least one of (i) a multiply-accumulate (MAC) operation, (ii) an addition, (iii) a computation of one or more activation functions, and (iii) a computation of Hadamard products of the one or more activation functions and a corresponding output of a past GRU operation from the plurality of GRU operations, and wherein the in memory computing IMC output represents an accumulated bitline current value; determining, via the one or more hardware processors, a digital value corresponding to each of the plurality of IMC output values using an analog-to-Digital Converter (ADC); and determining, via the one or more hardware processors, a final output value for each of the plurality of IMC output values based on accumulation of the digital value corresponding to each of the plurality of IMC output values with one or more bias input values provided by the one or more biasing circuit modules using the adder circuit module.

In another aspect, a system is provided. The system comprises a memory storing instructions; one or more communication interfaces; an In-Memory Computing (IMC) controller unit; and one or more hardware processors coupled to the memory and the IMC controller via the one or more communication interfaces, wherein the one or more hardware processors are configured by the instructions to: map a specific GRU weight network parameter from a plurality of GRU weight network parameter to each of a memristor array structure of a Resistive Random-Access Memory In-Memory Computing-based gated recurrent unit (RRAM IMC-based GRU) network architecture in a skewed arrangement for being stored, wherein the RRAM IMC-based GRU network architecture comprises a first storage unit, a second storage unit, an In Memory Computing (IMC) controller unit, and a reduced instruction set computing (RISC-V) based core processing unit, wherein the second storge unit comprises a plurality of modules that includes a first set of IMC circuit modules, a second set of IMC circuit modules, an output specific IMC circuit module, an adder circuit module, and one or more biasing circuit modules, and wherein each IMC circuit module in the first set of IMC circuit modules and the second set of IMC circuit modules comprise a plurality of RRAM devices that are arranged as a plurality of memristor array structures, wherein each memristor array structure from the plurality of memristor array structures comprises a plurality of rows and a plurality of columns connected by a plurality of memristive cells, and wherein each GRU weight network parameter represents a conductance value; input a multi-bit input vector to a plurality of rows of a first memristor array structure of the first set of IMC circuit modules that is mapped to a specific GRU weight network parameter and a past hidden state vector to the plurality of rows of a first memristor array structure of the second set of IMC circuit modules that is mapped to the corresponding specific GRU weight network parameter, wherein the multi-bit input vector and the past hidden state vector represent a voltage value; concurrently perform a plurality of GRU operations on the RRAM IMC-based GRU network architecture using the multi-bit input vector, the plurality GRU weight network parameters, and the past hidden state vector for obtaining a plurality of IMC output values, wherein the plurality of GRU operations are concurrently performed till an end of the multi-bit input vector application and a last value of the past hidden state vector is applied to the RRAM IMC-based GRU network architecture, and wherein the plurality of GRU operations comprise at least one of (i) a multiply-accumulate (MAC) operation, (ii) an addition, (iii) a computation of one or more activation functions, and (iii) a computation of Hadamard products of the one or more activation functions and a corresponding output of a past GRU operation from the plurality of GRU operations, and wherein the in memory computing IMC output represents an accumulated bitline current value; determine a digital value corresponding to each of the plurality of IMC output values using an analog-to-Digital Converter (ADC); and determine a final output value for each of the plurality of IMC output values based on accumulation of the digital value corresponding to each of the plurality of IMC output values with one or more bias input values provided by the one or more biasing circuit modules using the adder circuit module.

In yet another aspect, a non-transitory computer readable medium is provided. The non-transitory computer readable medium are configured by instructions for mapping a specific GRU weight network parameter from a plurality of GRU weight network parameter to each of a memristor array structure of a Resistive Random-Access Memory In-Memory Computing-based gated recurrent unit (RRAM IMC-based GRU) network architecture in a skewed arrangement for being stored, wherein the RRAM IMC-based GRU network architecture comprises a first storage unit, a second storage unit, an In Memory Computing (IMC) controller unit, and a reduced instruction set computing (RISC-V) based core processing unit, wherein the second storge unit comprises a plurality of modules that includes a first set of IMC circuit modules, a second set of IMC circuit modules, an output specific IMC circuit module, an adder circuit module, and one or more biasing circuit modules, and wherein each IMC circuit module in the first set of IMC circuit modules and the second set of IMC circuit modules comprise a plurality of RRAM devices that are arranged as a plurality of memristor array structures, wherein each memristor array structure from the plurality of memristor array structures comprises a plurality of rows and a plurality of columns connected by a plurality of memristive cells, and wherein each GRU weight network parameter represents a conductance value; inputting a multi-bit input vector to a plurality of rows of a first memristor array structure of the first set of IMC circuit modules that is mapped to a specific GRU weight network parameter and a past hidden state vector to the plurality of rows of a first memristor array structure of the second set of IMC circuit modules that is mapped to the corresponding specific GRU weight network parameter, wherein the multi-bit input vector and the past hidden state vector represent a voltage value; concurrently performing a plurality of GRU operations on the RRAM IMC-based GRU network architecture using the multi-bit input vector, the plurality GRU weight network parameters, and the past hidden state vector for obtaining a plurality of IMC output values, wherein the plurality of GRU operations are concurrently performed till an end of the multi-bit input vector application and a last value of the past hidden state vector is applied to the RRAM IMC-based GRU network architecture, and wherein the plurality of GRU operations comprise at least one of (i) a multiply-accumulate (MAC) operation, (ii) an addition, (iii) a computation of one or more activation functions, and (iii) a computation of Hadamard products of the one or more activation functions and a corresponding output of a past GRU operation from the plurality of GRU operations, and wherein the in memory computing IMC output represents an accumulated bitline current value; determining a digital value corresponding to each of the plurality of IMC output values using an analog-to-Digital Converter (ADC); and determining a final output value for each of the plurality of IMC output values based on accumulation of the digital value corresponding to each of the plurality of IMC output values with one or more bias input values provided by the one or more biasing circuit modules using the adder circuit module.

In accordance with an embodiment of the present disclosure, the step of concurrently performing plurality of GRU operations till the end of the multi-bit input vector application and the last value of the past hidden state vector is applied to the RRAM IMC-based GRU network architecture comprises: performing the MAC operation for (i) the multi-bit input vector and the corresponding specific GRU weight network parameter mapped to the first memristor array structure of the first set of IMC circuit modules, and (ii) the past hidden state vector and the corresponding specific GRU weight network parameter mapped to the first memristor array structure of the second set of IMC circuit modules to obtain a first MAC output; simultaneously computing (i) a second MAC output and (ii) a first activation function from the one or more activation functions using the first MAC output, wherein the second MAC output is computed by performing the MAC operation between the past hidden state vector and the corresponding specific GRU weight network parameter mapped to a second memristor array structure of the second set of IMC circuit modules; simultaneously computing (i) a third MAC output and (ii) a Hadamard product of the first activation function and the second MAC output, wherein the third MAC output is computed by performing the MAC operation between the multi-bit input vector and the corresponding specific GRU weight network parameter mapped to a second memristor array structure of the first set of IMC circuit modules; simultaneously computing (i) a fourth MAC output and (a) an accumulated Hadamard product of the first activation function, (b) the second MAC output, and (c) the third MAC output, wherein the fourth MAC output is computed by performing the MAC operation for (i) the multi-bit input vector and the corresponding specific GRU weight network parameter mapped to the third memristor array structure of the first set of IMC circuit modules, and (ii) the past hidden state vector and the corresponding specific GRU weight network parameter mapped to the third memristor array structure of the second set of IMC circuit modules; computing the first activation function and a second activation function for the fourth MAC output to obtain a fifth MAC output and a sixth MAC output; and obtaining a first intermediate output by performing a subtraction operation and a Hadamard product of the fifth MAC output and the sixth MAC output.

In accordance with an embodiment of the present disclosure, the step of concurrently performing plurality of GRU operations after the end of the multi-bit input vector application and the last value of the past hidden state vector is applied to the RRAM IMC-based GRU) network architecture comprises: performing the MAC operation on (i) a current hidden state vector obtained from the first intermediate output and (ii) an output GRU weight parameter stored in the output specific IMC circuit module to obtain a second intermediate output; and computing the first activation function of the second intermediate output such that the second intermediate output is restricted to a predefined range.

In accordance with an embodiment of the present disclosure, the first activation function is a sigmoid function.

In accordance with an embodiment of the present disclosure, the second activation function is a tangent hyperbolic function.

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 illustrates an exemplary system for Resistive Random-Access Memory (RRAM) based In-Memory Computing for efficient implementation of gated recurrent units, according to some embodiments of the present disclosure.
FIGS. 2A and 2B, with reference to FIG. 1, illustrate an exemplary flow diagram illustrating a method for Resistive Random-Access Memory (RRAM) based In-Memory Computing for efficient implementation of gated recurrent units, using the system of FIG. 1, in accordance with some embodiments of the present disclosure.

FIG. 3 illustrates a high level block diagram of the Resistive Random-Access Memory In-Memory Computing-based gated recurrent unit (RRAM IMC-based GRU) network architecture, according to some embodiments of the present disclosure.

FIG. 4 illustrates a block diagram of the second storage unit (i.e., IMC co-processor) for Resistive Random-Access Memory (RRAM) based In-Memory Computing for efficient implementation of gated recurrent units, according to some embodiments of the present disclosure.

FIGS. 5A and 5B illustrate an architecture diagram of the first set of IMC circuit modules and the second set of IMC circuit modules respectively of the second storage unit (i.e., IMC co-processor) for Resistive Random-Access Memory (RRAM) based In-Memory Computing for efficient implementation of gated recurrent units, according to some embodiments of the present disclosure.

FIG. 6 shows a diagram representing mapping of the specific GRU weight network parameter in each of the memristor array structure of the RRAM IMC-based GRU network architecture in a skewed arrangement, according to some embodiments of the present disclosure.

FIG. 7 shows a diagram depicting a design of a bitcell chosen in each memristor array structure for Resistive Random-Access Memory (RRAM) based In-Memory Computing for efficient implementation of gated recurrent units, according to some embodiments of the present disclosure.

FIG. 8 shows an exemplary flow diagram illustrating pipeline of the plurality of GRU operations at various stages for Resistive Random-Access Memory (RRAM) based In-Memory Computing for efficient implementation of gated recurrent units, according to some embodiments of the present disclosure.

FIGS. 9A through 9D depict graphical and block diagram representations illustrating simulation results of MAC operation of gate equation for Resistive Random-Access Memory (RRAM) based In-Memory Computing for efficient implementation of gated recurrent units, according to some embodiments of the present disclosure.

## DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments. It is intended that the following detailed description be considered as exemplary only, with the true scope being indicated by the following embodiments described herein.

Gated Recurrent unit (GRU), a type of recurrent neural network (RNN) is used for processing sequential time series data. Traditional GRU implementation based on von Neumann architectures, although proficient in managing sequential data for machine learning tasks, commonly face considerable energy overheads and latency challenges caused by frequent data transfers between memory and processing units.

The present disclosure addresses the unresolved problems of architecture design of the conventional approaches by hardware implementation of GRU using in-memory computing macro. Embodiments of the present disclosure provide a method and system for Resistive Random-Access Memory (RRAM) based In-Memory Computing for efficient implementation of gated recurrent units. In the system of the present disclosure, a Resistive Random-Access Memory (RRAM) based In-Memory Computing gated recurrent unit (RRAM IMC-based GRU) network architecture is provided that demonstrates substantial improvement in computational speed and is implemented for intrusion detection/sample networks. The present disclosure includes a design of a hardware circuit framework, which includes a GRU IMC circuit module and other peripherals, to perform fast and accurate analysis.

The Gated Recurrent Unit (GRU) is a type of recurrent neural network (RNN) architecture introduced to address a vanishing gradient problem. While preserving computing efficiency, GRUs seek to identify long-term dependencies in sequential data. A gating mechanism that controls the flow of information allows them to accomplish it. The GRU can reduce the vanishing gradient problem and effectively handle long-term dependencies by dynamically modifying a reset gate and an update gate. Compared to other gated architectures like Long Short-Term Memory (LSTM) network, this leads to higher performance for tasks involving sequential data, with fewer parameters, such as language modelling, time series prediction, and speech recognition. There are two main gates in the GRU architecture: an Update Gate and a Reset Gate. Information flow is managed by these gates, which enables a model to keep pertinent data and eliminate extraneous details. The Update Gate represented by $(z_t)$ determines an extent to which a past state should be retained and a new state should be incorporated. The Reset Gate represented by $(r_t)$ determines how much of past information to forget. A GRU operation can be described using the following equations (1) through (5):

$$r_t = \sigma(W_{ir}x_t + b_{ir} + W_{hr}h_{(t-1)} + b_{hr}) \qquad (1)$$

$$z_t = \sigma(W_{iz}x_t + b_{iz} + W_{hz}h_{(t-1)} + b_{hz}) \qquad (2)$$

$$n_t = tanh(W_{in}x_t + b_{in} + r_t \odot (W_{hn}h_{(t-1)} + b_{hn})) \qquad (3)$$

$$h_t = (1 - z_t) \odot n_t + z_t \odot h_{(t-1)} \qquad (4)$$

$$y = \sigma(W_{out}h_t + b_{out}) \qquad (5)$$

Further, In-memory computing architectures intrinsically showcase advantages in power efficiency and throughput by eliminating a need for data movement from memory and also exhibit prominent parallelism when performing MAC operations. In the system of present disclosure, a Resistive Random-Access Memory In-Memory Computing-based gated recurrent unit (RRAM IMC-based GRU) network architecture is used which performs Multiply-Accumulate (MAC) operations using Ohm's law for multiplication and Kirchhoff's current law for accumulation. A matrix is mapped as device conductance (LRS and HRS) in a Resistive Random-Access Memory (RRAM) array, and an input vector is applied as voltage pulses to wordlines of the RRAM array corresponding to values which should be multiplied and accumulated. Results of the MAC operation are obtained as bitline currents, which are then sampled and converted to digital values using an Analog-to-Digital Converters (ADC) for interfacing with other digital post-processing units. Bit-precision of weights and inputs is usually multi-bit, which makes it impractical to map the weights into one RRAM device. To overcome these challenges, in the present disclosure, these weights are mapped across different RRAM devices using various mapping strategies to realize multi-bit MAC operations.

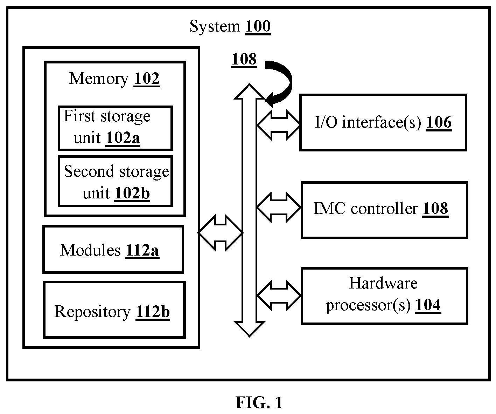

Referring now to the drawings, and more particularly to FIGS. 1 through 10, where similar reference characters denote corresponding features consistently throughout the figures, there are shown preferred embodiments, and these embodiments are described in the context of the following exemplary system and/or method.

FIG. 1 illustrates an exemplary system for Resistive Random-Access Memory (RRAM) based In-Memory Computing for efficient implementation of gated recurrent units, according to some embodiments of the present disclosure. In an embodiment, the system 100 includes or is otherwise in communication with one or more hardware processors 104, communication interface device(s) or input/output (I/O) interface(s) 106, an In-Memory Computing (IMC) controller unit 108 and one or more data storage devices/units or memory 102 operatively coupled to the one or more hardware processors 104. The one or more hardware processors 104, the memory 102, The IMC controller unit 108, and the I/O interface(s) 106 may be coupled to a system bus 110 such as a wishbone bus or a similar mechanism.

The I/O interface(s) 106 may include a variety of software and hardware interfaces, for example, a web interface, a graphical user interface, and the like. The I/O interface(s) 106 may include a variety of software and hardware interfaces, for example, interfaces for peripheral device(s), such as a keyboard, a mouse, an external memory, a plurality of sensor devices, a printer and the like. Further, the I/O interface(s) 106 may enable the system 100 to communicate with other devices, such as web servers and external databases.

The I/O interface(s) 106 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface(s) 106 may include one or more ports for connecting a number of computing systems with one another or to another server computer. Further, the I/O interface(s) 106 may include one or more ports for connecting a number of devices to one another or to another server.

The one or more hardware processors 104 may be implemented as one or more microprocessors, a reduced instruction set computing (RISC-V) based core processing unit, an In Memory Computing (IMC) Co-processor, microcomputers, microcontrollers, digital signal processors, central processing units, state machines, logic circuitries, and/or any devices that manipulate signals based on operational instructions. Among other capabilities, the one or more hardware processors 104 are configured to fetch and execute computer-readable instructions stored in the memory 102. In the context of the present disclosure, the expressions 'processors' and 'hardware processors' may be used interchangeably. In an embodiment, the system 100 can be implemented in a variety of computing systems, such as laptop computers, portable computer, notebooks, hand-held devices, workstations, mainframe computers, servers, a network cloud and the like. The IMC coprocessor is interfaced with the RISC-V based core processing unit through the wishbone bus, which has a dedicated address and data bus for I/O communication. The RISC-V core based core processing unit is used to perform some GRU operations.

The memory 102 may include any computer-readable medium known in the art including, for example, volatile memory, such as static random access memory (SRAM), dynamic random access memory (DRAM), resistive random access memory (RRAM), and/or non-volatile memory, such as read only memory (ROM), erasable programmable ROM, flash memories, hard disks, optical disks, and magnetic tapes. The memory 102 includes a first storage unit 102a, a second storage unit 102b. In an embodiment, the second storage unit 102b includes a plurality of modules 112a and a repository 112b for storing data processed, received, and generated by one or more of the plurality of modules 112a. The plurality of modules 112a may include routines, programs, objects, components, data structures, and so on, which perform particular tasks or implement particular abstract data types.

In an embodiment, the plurality of modules 112a comprises a first set of In-Memory Computing (IMC) circuit modules, a second set of IMC circuit modules, an output specific IMC circuit module, an adder circuit module, and one or more biasing circuit modules. The plurality of modules 112a may include programs or computer-readable instructions or coded instructions that supplement applications or functions performed by the system 100. The plurality of modules 112a may also be used as, signal processor(s), state machine(s), logic circuitries, and/or any other device or component that manipulates signals based on operational instructions. Further, the plurality of modules 112a can be used by hardware, by computer-readable instructions executed by the one or more hardware processors 104, or by a combination thereof. Further, the memory 102 may include information pertaining to input(s)/output(s) of each step performed by the processor(s) 104 of the system 100 and methods of the present disclosure.

The repository 112b may include a database or a data engine. Further, the repository 112b amongst other things may serve as a database or includes a plurality of databases for storing the data that is processed, received, or generated as a result of the execution of the plurality of modules 112a. Although the repository 112b is shown internal to the system 100, it will be noted that, in alternate embodiments, the repository 112b can also be implemented external to the system 100, where the repository 112b may be stored within an external database (not shown in FIG. 1 communicatively coupled to the system 100. The data contained within such an external database may be periodically updated. For example, new data may be added into the external database and/or existing data may be modified and/or non-useful data may be deleted from the external database. In one example, the data may be stored in an external system, such as a Lightweight Directory Access Protocol (LDAP) directory and a Relational Database Management System (RDBMS). In another embodiment, the data stored in the repository 112b may be distributed between the system 100 and the external database.

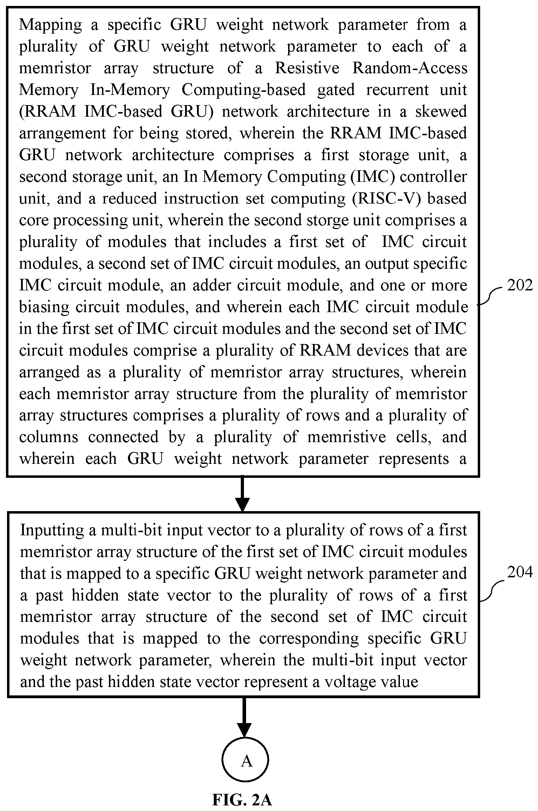

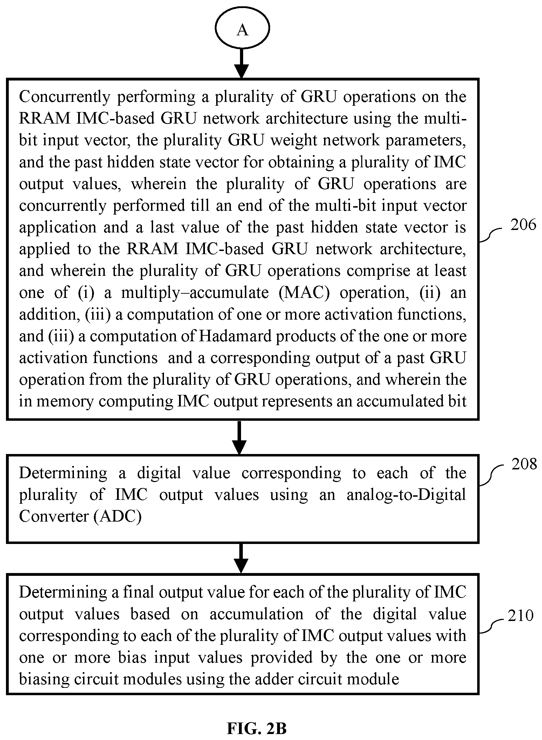

FIGS. 2A and 2B, with reference to FIG. 1, illustrate an exemplary flow diagram illustrating a method for Resistive Random-Access Memory (RRAM) based In-Memory Computing for efficient implementation of gated recurrent units, using the system of FIG. 1, in accordance with some embodiments of the present disclosure.

Referring to FIGS. 2A and 2B, in an embodiment, the system(s) 100 comprises one or more data storage devices or the memory 102 operatively coupled to the one or more hardware processors 104 and is configured to store instructions for execution of steps of the method by the one or more processors 104. The steps of the method 200 of the present disclosure will now be explained with reference to components of the system 100 of FIG. 1, the flow diagram as depicted in FIGS. 2A and 2B, and one or more examples. Although steps of the method 200 including process steps, method steps, techniques or the like may be described in a sequential order, such processes, methods and techniques may be configured to work in alternate orders. In other words, any sequence or order of steps that may be described does not necessarily indicate a requirement that the steps be performed in that order. The steps of processes described herein may be performed in any practical order. Further, some steps may be performed simultaneously, or some steps may be performed alone or independently.

In an embodiment, at step 202 of the present disclosure, one or more hardware processors 104 are configured to map a specific GRU weight network parameter from a plurality of GRU weight network parameter to each of a memristor array structure of a Resistive Random-Access Memory In-Memory Computing-based gated recurrent unit (RRAM IMC-based GRU) network architecture in a skewed arrangement for being stored.

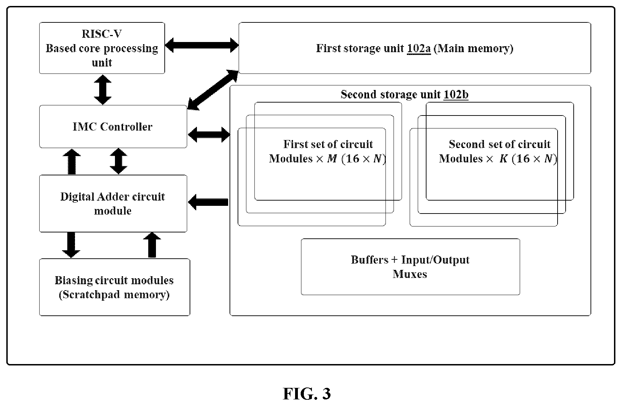

FIG. 3 illustrates a high-level block diagram of the Resistive Random-Access Memory In-Memory Computing-based gated recurrent unit (RRAM IMC-based GRU) network architecture, according to some embodiments of the present disclosure. The RRAM IMC-based GRU network architecture comprises a first storage unit, a second storage unit, an In Memory Computing (IMC) controller unit, and a reduced instruction set computing (RISC-V) based core processing unit. In the context of the present disclosure, the first storage unit 102a is used as a main memory and the second storage unit is used as an IMC co-processor. As shown in FIG. 3, RISC-V based CPU is used as a general purpose compute unit, which is interfaced with the main memory and the IMC controller. The second storage unit 102b is interfaced with the RISC-V through a wishbone bus, which has a dedicated address and data bus for I/O communication. The second storage unit comprises a plurality of modules that includes a first set of in-memory computing IMC circuit modules, a second set of IMC circuit modules, an output specific IMC circuit module, an adder circuit module, and one or more biasing circuit modules.

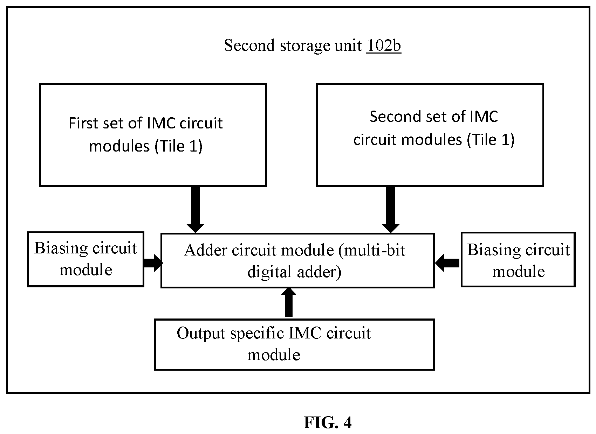

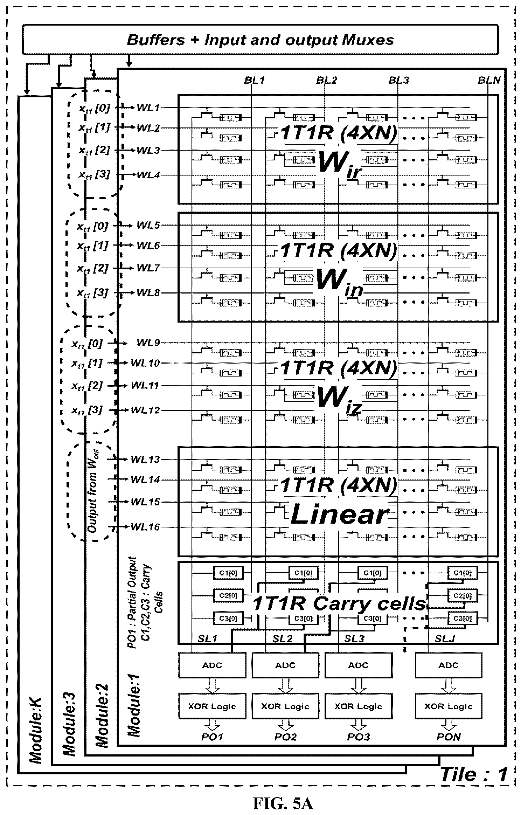

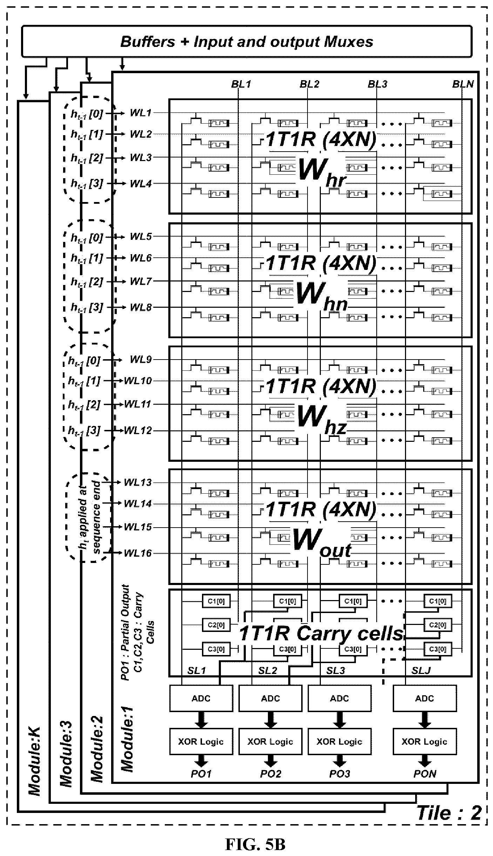

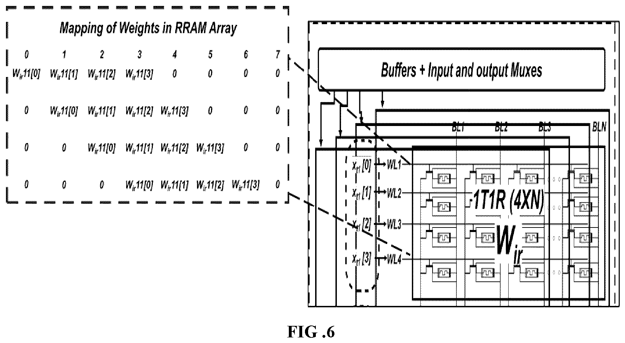

FIG. 4 illustrates a block diagram of the second storage unit (i.e., IMC co-processor) for Resistive Random-Access Memory (RRAM) based In-Memory Computing for efficient implementation of gated recurrent units, according to some embodiments of the present disclosure. In the context of the present disclosure, the first set of IMC circuit modules is alternatively referred to as 'Tile 1' and the second set of IMC circuit modules as 'Tile 2' throughout the description. FIGS. 5A and 5B illustrate an architecture diagram of the first set of IMC circuit modules and the second set of IMC circuit modules respectively of the second storage unit (i.e., IMC co-processor) for Resistive Random-Access Memory (RRAM) based In-Memory Computing for efficient implementation of gated recurrent units, according to some embodiments of the present disclosure. As shown in FIGS. 5A and 5B, each IMC circuit module in the first set of IMC circuit modules and the second set of IMC circuit modules comprise a plurality of RRAM devices that are arranged as a plurality of memristor array structures. Here, each memristor array structure from the plurality of memristor array structures comprises a plurality of rows and a plurality of columns connected by a plurality of memristive cells. In the context of the present disclosure, each memristor array structure represents a one transistor- one resistor (1T-1R) array. FIG. 6 shows a diagram representing mapping of the specific GRU weight network parameter in each of the memristor array structure of the RRAM IMC-based GRU network architecture in a skewed arrangement, according to some embodiments of the present disclosure. As shown in FIG. 6, each specific GRU weight network parameter from the plurality of GRU weight network parameters represents a weight matrix comprising a plurality of weight elements. As was shown in FIG. 4, the first set of in-memory computing IMC circuit modules and the second set of IMC circuit modules include six memristor arrays, which are allocated to the specific GRU weight network parameter from the plurality of GRU weight network parameters represented by $W_{ir}$, $W_{iz}$, $W_{in}$ and $W_{hr}$, $W_{hz}$, $W_{hn}$ respectively. Dimension of each of the plurality of GRU weight network parameter is same/identical. The GRU weight network parameter $W_{ir}$, $W_{iz}$, $W_{in}$ are stored in same tile (i.e., 'Tile 1') across M modules and $W_{hr}$, $W_{hz}$, $W_{hn}$ are stored across K modules of another tile (i.e., 'Tile 2') in a skewed manner as. This is due to a possible matrix size difference between $W_{ir}$, $W_{iz}$, $W_{in}$ and $W_{ar}$, $W_{hz}$, $W_{hn}$. The number of modules (M and K) in the Tile 1 and Tile 2 depends on size of the specific GRU weight network parameter. In an embodiment, each GRU weight network parameter represents a conductance value. Each memristor cell (alternatively referred as RRAM cell) in each memristor array structure has a resistance that can be modulated based on stored data with logic states such as "0" or "1". Here, resistance levels correspond to the stored data and can be used to represent different GRU weight network parameters. Further, as shown in FIG. 4, one output specific IMC circuit module of size 4XN is reserved separately for $W_{out}$, which is a last operation in a GRU algorithm.

At step 204 of the present disclosure, the one or more hardware processors 104 are configured to input a multi-bit input vector to a plurality of rows of a first memristor array structure of the first set of IMC circuit modules that is mapped to the specific GRU weight network parameter and a past hidden state vector to the plurality of rows of the first memristor array structure of the second set of IMC circuit modules that is mapped to the corresponding specific GRU weight network parameter. Here, the first memristor array structure of the first set of IMC circuit modules represents the memristor array structure of the Tile 1 allocated to GRU weight network parameter $W_{ir}$ and the first memristor array structure of the second set of IMC circuit modules represents the memristor array structure of the Tile 2 allocated to GRU weight network parameter $W_{hr}$.

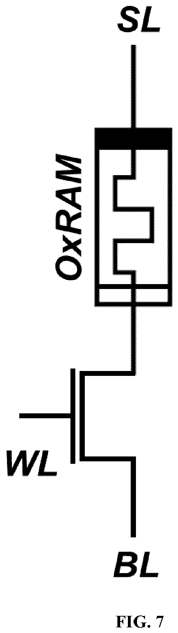

In an embodiment, the multi-bit input vector and the past hidden state vector represent a voltage value. Unlike Binary Neural Networks, the plurality of weight elements in each of the plurality of GRU weight network parameters and the multi-bit input vector of GRU are multi-bit numbers. FIG. 7 shows a diagram depicting a design of a bitcell chosen in each memristor array structure for Resistive Random-Access Memory (RRAM) based In-Memory Computing for efficient implementation of gated recurrent units, according to some embodiments of the present disclosure. As shown in FIG. 7, the bitcell chosen in each memristor array structure is 1T-1R, which is used to perform 4-bit multiply and accumulate operations. In FIG. 7, WL represents a wordline and BL represents a bitline. Table 1 below provides a truth table for logic AND operation for 1T-1R bit cell.

Table 1

| Input (WL) | Weight (RRAM) | Output (BL) |
|---|---|---|
| 0 | 0(HRS) | 0 |
| 0 | 1(LRS) | 0 |
| 1 | 0(HRS) | $V_{HRS}$ |
| 1 | 1(LRS) | $V_{LRS}$ |

Table 2 provides design parameters used for configuring the second storage unit (i.e., IMC co-processor).

Table 2

| Parameter | Value |
|---|---|
| RRAM - LRS | 10K |
| RRAM - HRS | 500K |
| NMOS Length | 400nm |

(continued)

| Parameter | Value |
|---|---|
| NMOS Width | 300nm |
| No: Fingers | 8 |

Each of the plurality of GRU weight network parameters are stored in a set of 4 rows. The multi-bit input vector represented by $x_t$ and the past hidden state vector represented by $h_{t-1}$ are applied as inputs to the memristor array structures of the first set of IMC circuit modules and the second set of IMC circuit modules through wordlines. These inputs are applied in a particular sequence in order to pipeline the process of computing MAC outputs for various weight matrices. The inputs (i.e., the multi-bit input vector and the past hidden state vector) representing voltages are applied to the plurality of rows (i.e., wordlines), and output currents are read from the plurality of columns (i.e., bitlines). The plurality of weight elements in each weight matrix are stored as conductance values in the plurality of memristive cells at an intersection of the wordlines and bitlines.

Referring to FIG. 2B, at step 206 of the present disclosure, the one or more hardware processors 104 are configured to concurrently perform a plurality of GRU operations on the RRAM IMC-based GRU network architecture using the multibit input vector, the plurality GRU weight network parameters, and the past hidden state vector for obtaining a plurality of IMC output values. The plurality of GRU operations are concurrently performed until an end of the multi-bit input vector application and a last value of the past hidden state vector is applied to the RRAM IMC-based GRU network architecture. The plurality of GRU operations comprise at least one of (i) a multiply-accumulate (MAC) operation, (ii) an addition, (iii) a computation of one or more activation functions, and (iv) a computation of Hadamard products of the one or more activation functions and a corresponding output of a past GRU operation from the plurality of GRU operations. An IMC output value represents an accumulated bitline current value.

For each element in the multi-bit input vector, a corresponding voltage is applied to the wordline of a memristor array structure. The plurality of memristive cells modulate currents based on their conductance. This is a multiplication step, where an input voltage is multiplied by conductance of the plurality of memristive cells (representing weight elements in each of the weight matrix (i.e., GRU weight network parameter)). Resulting currents from different memristive cells are summed along bitline due to Kirchhoff's Current Law (KCL). This summing of currents naturally implements the accumulation step of the MAC operation. If the multi-bit input vector and the specific GRU weight network parameter are 4-bits, 4 bits are applied in parallel to the wordline of the memristor array structure allocated to that specific GRU weight network parameter and 4-bit data is stored in the first set of IMC circuit modules and the second set of IMC circuit modules in a skewed manner.

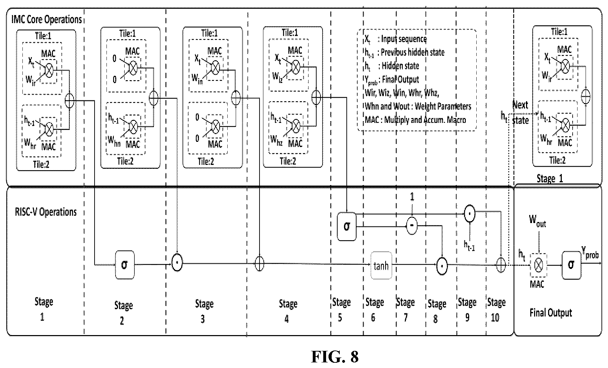

The step of concurrently performing the plurality of GRU operations till the end of the multi-bit input vector application and the last past hidden state vector is applied to the RRAM IMC-based GRU network architecture comprises first performing the MAC operation for (i) the multi-bit input vector and the corresponding specific GRU weight network parameter mapped to the first memristor array structure of the first set of IMC circuit modules, and (ii) the past hidden state vector and the corresponding specific GRU weight network parameter mapped to the first memristor array structure of the second set of IMC circuit modules to obtain a first MAC output. Here, the corresponding specific GRU weight network parameter mapped to the first memristor array structure of the first set of IMC circuit modules is $W_{ir}$ and the corresponding specific GRU weight network parameter mapped to the first memristor array structure of the second set of IMC circuit modules is $W_{hr}$. FIG. 8 shows an exemplary flow diagram illustrating pipeline of the plurality of GRU operations at various stages for Resistive Random-Access Memory (RRAM) based In-Memory Computing for efficient implementation of gated recurrent units, according to some embodiments of the present disclosure. As shown in FIG. 8, the plurality of GRU weight network parameters $W_{ir}$, $W_{iz}$, $W_{in}$ and $W_{hr}$, $W_{hz}$, $W_{hn}$ are stored in each memristor array structure of the first set of IMC circuit modules and the second set of IMC circuit modules respectively in a skewed manner. As a first step, at stage 1, the multi-bit input vector ($x_t$) and the past hidden state vector ($h_{t-1}$), each 4-bit wide are applied to the wordlines of $W_{ir}$ and $W_{hr}$ respectively. For the MAC operation, a multiplication step is performed between the multi-bit input vector ($x_t$) and $W_{ir}$. Similarly, the multiplication is performed between the past hidden state vector ($h_{t-1}$) and $W_{hr}$. Ohm's Law is used for performing multiplication since current flowing through a memristor is proportional to applied voltage and resistance (representing the stored weight). An accumulation required for the multiplication of 4 bits is performed using an in-memory carry propagation technique, which eliminates requirement of adders at the basic multibit multiplication level. This is achieved with only three extra 1T-1R bit cells per column also referred to as carry cell. As a result of the MAC operation at stage 1, the first MAC output is obtained.

Further, (i) a second MAC output and (ii) a first activation function is from the one or more activation functions are simultaneously computed using the first MAC output. The second MAC output is computed by performing the MAC operation between the past hidden state vector ($h_{t-1}$) and the corresponding specific GRU weight network parameter mapped to a second memristor array structure of the second set of IMC circuit modules. The corresponding specific GRU weight network parameter mapped to the second memristor array structure of the second set of IMC circuit modules is represented by $W_{hn}$. In an embodiment, the first activation function is a sigmoid function. As shown in FIG. 8, as a second step, at stage 2, the first MAC output from the second storage unit (i.e., IMC co-processor) is sent to the RISC-V CPU for computing the sigmoid function to the first MAC output (i.e., stage1 output). At the same time the past hidden state vector ($h_{t-1}$) is applied to $W_{hn}$ which provides the second MAC output in stage 2.

Furthermore, (i) a third MAC output and (ii) a Hadamard product of the first activation function and the second MAC output, are simultaneously computed. The third MAC output is computed by performing the MAC operation between the multi-bit input vector and the corresponding specific GRU weight network parameter mapped to a second memristor array structure of the first set of IMC circuit modules. The corresponding specific GRU weight network parameter mapped to the second memristor array structure of the first set of IMC circuit modules is represented by $W_{in}$. As shown in FIG. 8, as a third step, at stage 3, the Hadamard product of the sigmoid function and the second MAC output (i.e., output from previous stage which is stage 2) is performed in the RISC-V CPU. At the same time the multi-bit input vector ($x_t$) is applied to $W_{in}$ in the second storage unit (i.e., IMC co-processor) for performing the MAC operation.

After stage 3, (i) a fourth MAC output and (a) an accumulated Hadamard product of the first activation function, (b) the second MAC output, and (c) the third MAC output are simultaneously computed. The fourth MAC output is computed by performing the MAC operation for (i) the multi-bit input vector and the corresponding specific GRU weight network parameter mapped to the first memristor array structure of the first set of IMC circuit modules, and (ii) the past hidden state vector and the corresponding specific GRU weight network parameter mapped to the third memristor array structure of the second set of IMC circuit modules. The corresponding specific GRU weight network parameter mapped to the third memristor array structure of the first set of IMC circuit modules is represented by $W_{iz}$. The corresponding specific GRU weight network parameter mapped to the third memristor array structure of the second set of IMC circuit modules is represented by $W_{hz}$. As shown in FIG. 8, as a fourth step, at stage 4, the results from Hadamard product is accumulated with the results from MAC operation from stage 3 and the multi-bit input vector ($x_t$) and the past hidden state vector ($h_{t-1}$) are applied to $W_{iz}$ and $W_{hz}$ respectively in the second storage unit (i.e., IMC co-processor).

Further, the first activation function and a second activation function for the fourth MAC output is computed to obtain a fifth MAC output and a sixth MAC output. In an embodiment, the second activation function is a tangent hyperbolic function. As shown in FIG. 8, at stage 5 and stage 6, the sigmoid function of output from stage 4 operation is performed in RISC-V CPU and the tangent hyperbolic function (tanh) activation of stage 4 accumulation is performed respectively. Stage 5 provides the fifth MAC output and stage 6 provides the sixth MAC output.

Furthermore, a first intermediate output is obtained by performing a subtraction operation and a Hadamard product of the fifth output and the sixth output. As shown in FIG. 8, in stage 7, the hadamard product of the outputs of stage 5 and 6 are performed. In stage 8, the result of stage 7 is subtracted from 1 as per the equation (4). In stage 9, the Hadamard product of the past hidden state vector ($h_{t-1}$) and the output of stage 8 is performed. In stage 10, final accumulation is performed to obtain the first intermediate output. Stages 1 to 10 are repeated till the end of the multi-bit input vector application and the last value of the past hidden state vector is applied to the RRAM IMC-based GRU network architecture.

In an embodiment, the step of concurrently performing plurality of GRU operations after the end of the multi-bit input vector application and the last value of the past hidden state vector is applied to the RRAM IMC-based GRU) network architecture comprises performing the MAC operation on (i) a current hidden state vector obtained from the first intermediate output and (ii) an output GRU weight parameter stored in the output specific IMC circuit module to obtain a second intermediate output. Further, the first activation function of the second intermediate output is computed such that the second intermediate output is restricted to a predefined range. The current hidden state is represented by $h_t$ and the output GRU weight parameter stored in the output specific IMC circuit module is represented by $W_{out}$. As shown in FIG. 7, at last $h_t$ is applied to the second storage unit (i.e., IMC co-processor) with $W_{out}$ to obtain the second intermediate output. Further, a sigmoid function of the second intermediate output is computed which restricts the second intermediate output to the predefined range of 0-1.

At step 208 of the present disclosure, one or more hardware processors 104 are configured to determine a digital value corresponding to each of the plurality of IMC output values using an Analog-to-Digital Converter (ADC). The first set of in-memory computing IMC circuit modules and the second set of IMC circuit modules also comprises of Analog to Digital Converters (ADCs) to provide a pop count of number of active memristive cells (i.e., RRAM cells) in a Low Resistance State (LRS) state in a particular column, input and output analog muxes, which supply READ/SET/RESET/FORM pulses required for the memristor array structures and XOR (Exclusive OR) logic to convert pop-count to a binary digital representation.

Further, at step 210 of the present disclosure, one or more hardware processors 104 are configured to determine a final output value for each of the plurality of IMC output values based on accumulation of the digital value corresponding to each of the plurality of IMC output values with one or more bias input values provided by the one or more biasing circuit modules using the adder circuit module. The outputs from the first set of in-memory computing IMC circuit modules and the second set of IMC circuit modules are fed into the adder circuit module which is a digital adder circuit module. The adder circuit module computes a final output after adding the one or more bias input values with outputs from different modules as per the GRU algorithm mentioned in equations (1), (2), (3) and (4). The elements of each of the specific GRU weight parameters (i.e., the weight matrix) are stored across different modules in order to obtain the results in parallel and for better computation efficiency. The final output is represented by $y_{prob}$.

**WORKLOAD ANALYSIS AND ACCURACY**

The RRAM IMC-based GRU network is trained using python in 8 or 4 bit quantized weights. For improving accuracy, quantization aware training was used. Upon training the RRAM IMC-based GRU network for maximum accuracy, the plurality of GRU weight parameters $W_{ir}$, $W_{in}$, $W_{iz}$ and $W_{ir}$, $W_{in}$, $W_{iz}$ have been extracted from a model file. If model is trained using 4-bit quantization, the plurality of GRU weight parameters are stored directly in the memristor array structure in a skewed manner and the plurality of GRU operations are performed to obtain a final GRU output. Accuracy of the GRU output remains same or close to the accuracy obtained using python.

If the model is trained using 8-bit quantization, the plurality of GRU weight parameters and inputs are split into 4-bits and computed using equation (6) below:

$$A_{ij} \times V_j = (A_{ij}^{hi} \times V_j^{hi}) << 8 + (A_{ij}^{hi} \times V_j^{lo}) << 4 + (A_{ij}^{lo} \times V_j^{hi}) <$$
$$< 4 + (A_{ij}^{lo} \times V_j^{lo}) \quad (6)$$

Here, $A$ represents the specific GRU weight parameter and $V$ represents the multi-bit input vector. If $A_{ij}$ is 10110001 and $V_j$ is 10011100, then $A_{ij}^{hi}$ (high 4-bits = 1011) and $A_{ij}^{lo}$ (low 4-bits=0001), $V_j^{hi}$ (high 4-bits=1001) and $V_j^{lo}$ (low 4-bits=1100) << is shift operation. Upon doing this, the plurality of operations are converted into 4-bit operations with shift and add. Use of 8-bit introduces 4 times more latency since 4 different 4-bit multiplication operations with shift and add is required for multiplication of two 8-bit numbers. Remaining steps are same as that of 4-bit quantized and the accuracy is same or close to that of python estimates. The obtained accuracy for a 8-bit quantized FordA dataset for GRU network is 89.36% (Obtained from python implementation). Circuit design, simulation and waveform estimates of the RRAM IMC-based GRU network architecture were performed in Cadence Virtuoso software® using TSMC 65nm technology node. Table 3 below values of different design parameters associated with the RRAM IMC-based GRU network architecture.

Table 3

| Parameter | Value |
|---|---|
| Technology | TSMC 65nm + RRAM |
| Macro size | 1.5KB |
| Bit-cell type | 1T-1R (AND) |
| Input, weight (bits) | 4,4 |
| Cycle time (ns) | 12 |
| IMC array (mW) | 73.1 |
| ADC power (mW) | 115 |
| XOR block power (mW) | 0.228 |
| Multibit digital adder power (mW) | 0.372 |

**EXPERIMENTAL RESULTS**

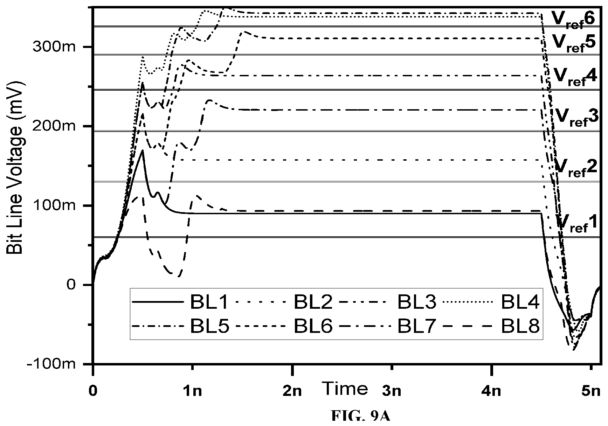

For the evaluation of the RRAM IMC-based GRU network architecture, the architecture is implemented in TSMC 65 nm technology. FIGS. 9A through 9D depict graphical and block diagram representations illustrating simulation results of MAC operation of gate equation for Resistive Random-Access Memory (RRAM) based In-Memory Computing for efficient implementation of gated recurrent units, according to some embodiments of the present disclosure. The simulation has been carried out on an example network with an input ($x_t$) of sequence size $2 \times 1$ and a weight matrix ($W_{ir}$) with dimensions $10 \times 2$. The past hidden state ($h_{t-1}$) has a size of $10 \times 1$, and the weight matrix ($W_{hr}$) is sized $10 \times 10$.

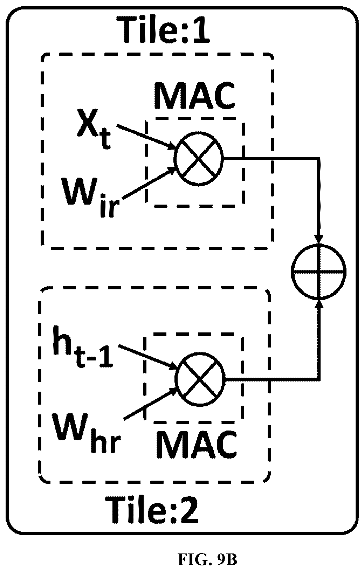

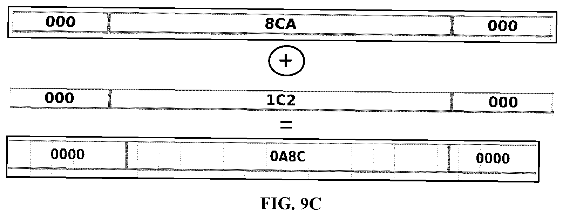

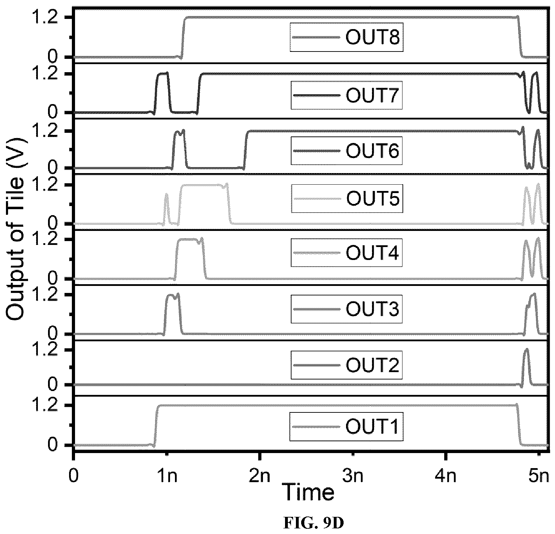

FIG. 9A depicts a graphical representation illustrating bitline voltages for various MAC values and reference voltages for sensing, for Resistive Random-Access Memory (RRAM) based In-Memory Computing for efficient implementation of gated recurrent units, according to some embodiments of the present disclosure. FIG. 9B shows a block diagram representation of implementation of MAC operation for a given network in IMC tiles as per RRAM IMC-based GRU network architecture, according to some embodiments of the present disclosure. The input and weight parameter is kept as a 4-bit value "1111" for both the multi-bit input vector (i.e., input sequence) and the past hidden state vector. The MAC operation on the multi-bit input vector and the past hidden state vector is performed in different modules of each tile and then added using the digital adder circuit modules to get the final output. The inputs to this digital adder circuit module are obtained from IMC co-processor in a single clock cycle. The digital adder circuit module is asynchronous and performs addition upon enable signal being active. FIG. 9C depicts a graphical representation illustrating the digital adder circuit modules output, for Resistive Random-Access Memory (RRAM) based In-Memory Computing for efficient implementation of gated recurrent units, according to some embodiments of the present disclosure. As shown in FIG. 9C, the output of Tile 1 as "1C2", Tile 2 as "8CA", and the outputs "1C2" and "8CA" are added to obtain the final output "0A8C". FIG. 9D depicts a representation illustrating digital output from multi-bit digital adder block, for Resistive Random-Access Memory (RRAM) based In-Memory Computing for efficient implementation of gated recurrent units, according to some embodiments of the present disclosure. During MAC operation of two 4-bit numbers, each being "1111" and a corresponding 8-bit sensed digital output of analog to digital converter and XOR logic is shown in FIG. 9D.

The written description describes the subject matter herein to enable any person skilled in the art to make and use the embodiments. The scope of the subject matter embodiments is defined herein and may include other modifications that occur to those skilled in the art. Such other modifications are intended to be within the scope of the present disclosure if they have similar elements that do not differ from the literal language of the embodiments or if they include equivalent elements with insubstantial differences from the literal language of the embodiments described herein.

The present disclosure provides energy efficiency and enables parallelism. Since computation happens directly within the memory, there is no need to shuttle data back and forth between memory and processing units, leading to significant energy savings. The RRAM IMC-based GRU network architecture allows for highly parallel computations, where multiple MAC operations can be performed simultaneously, improving throughput.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an applicationspecific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computerusable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated herein by the following claims.

**Claims**

1. A processor implemented method (200), comprising:

mapping (202), via one or more hardware processors, a specific GRU weight network parameter from a plurality of GRU weight network parameter to each of a memristor array structure of a Resistive Random-Access Memory In-Memory Computing-based gated recurrent unit (RRAM IMC-based GRU) network architecture in a skewed arrangement for being stored, wherein the RRAM IMC-based GRU network architecture comprises a first storage unit, a second storage unit, an In Memory Computing (IMC) controller unit, and a reduced instruction set computing (RISC-V) based core processing unit, wherein the second storge unit comprises a plurality of modules that includes a first set of IMC circuit modules, a second set of IMC circuit modules, an output specific IMC circuit module, an adder circuit module, and one or more biasing circuit modules, and wherein each IMC circuit module in the first set of IMC circuit modules and the second set of IMC circuit modules comprise a plurality of RRAM devices that are arranged as a plurality of memristor array structures, wherein each memristor array structure from the plurality of memristor array structures comprises a plurality of rows and a plurality of columns connected by a plurality of memristive cells, and wherein each GRU weight network parameter represents a conductance value;

inputting (204), via the one or more hardware processors, a multi-bit input vector to a plurality of rows of a first memristor array structure of the first set of IMC circuit modules that is mapped to a specific GRU weight network parameter and a past hidden state vector to the plurality of rows of a first memristor array structure of the second set of IMC circuit modules that is mapped to the corresponding specific GRU weight network parameter, wherein the multi-bit input vector and the past hidden state vector represent a voltage value;

concurrently performing (206), via the one or more hardware processors, a plurality of GRU operations on the RRAM IMC-based GRU network architecture using the multi-bit input vector, the plurality GRU weight network parameters, and the past hidden state vector for obtaining a plurality of IMC output values, wherein the plurality of GRU operations are concurrently performed till an end of the multi-bit input vector application and a last value of the past hidden state vector is applied to the RRAM IMC-based GRU network architecture, and wherein the plurality of GRU operations comprise at least one of (i) a multiply-accumulate (MAC) operation, (ii) an addition, (iii) a computation of one or more activation functions, and (iii) a computation of Hadamard products of the one or more activation functions and a corresponding output of a past GRU operation from the plurality of GRU operations, and wherein the in memory computing IMC output represents an accumulated bitline current value;

determining (208), via the one or more hardware processors, a digital value corresponding to each of the plurality of IMC output values using an analog-to-Digital Converter (ADC); and

determining (210), via the one or more hardware processors, a final output value for each of the plurality of IMC output values based on accumulation of the digital value corresponding to each of the plurality of IMC output values with one or more bias input values provided by the one or more biasing circuit modules using the adder circuit module.

2. The processor implemented method as claimed in claim1, wherein the step of concurrently performing plurality of GRU operations till the end of the multibit input vector application and the last value of the past hidden state vector is applied to the RRAM IMC-based GRU network architecture comprises:

performing the MAC operation for (i) the multi-bit input vector and the corresponding specific GRU weight network parameter mapped to the first memristor array structure of the first set of IMC circuit modules, and (ii) the past hidden state vector and the corresponding specific GRU weight network parameter mapped to the first memristor array structure of the second set of IMC circuit modules to obtain a first MAC output;

simultaneously computing (i) a second MAC output and (ii) a first activation function from the one or more activation functions using the first MAC output, wherein the second MAC output is computed by performing the MAC operation between the past hidden state vector and the corresponding specific GRU weight network parameter mapped to a second memristor array structure of the second set of IMC circuit modules;

simultaneously computing (i) a third MAC output and (ii) a Hadamard product of the first activation function and the second MAC output, wherein the third MAC output is computed by performing the MAC operation between the multi-bit input vector and the corresponding specific GRU weight network parameter mapped to a second memristor array structure of the first set of IMC circuit modules;
simultaneously computing (i) a fourth MAC output and (a) an accumulated Hadamard product of the first activation function, (b) the second MAC output, and (c) the third MAC output, wherein the fourth MAC output is computed by performing the MAC operation for (i) the multi-bit input vector and the corresponding specific GRU weight network parameter mapped to the third memristor array structure of the first set of IMC circuit modules, and (ii) the past hidden state vector and the corresponding specific GRU weight network parameter mapped to the third memristor array structure of the second set of IMC circuit modules;
computing the first activation function and a second activation function for the fourth MAC output to obtain a fifth MAC output and a sixth MAC output; and
obtaining a first intermediate output by performing a subtraction operation and a Hadamard product of the fifth MAC output and the sixth MAC output.

3. The processor implemented method as claimed in claim 2, wherein the step of concurrently performing plurality of GRU operations after the end of the multibit input vector application and the last value of the past hidden state vector is applied to the RRAM IMC-based GRU) network architecture comprises:

performing the MAC operation on (i) a current hidden state vector obtained from the first intermediate output and (ii) an output GRU weight parameter stored in the output specific IMC circuit module to obtain a second intermediate output; and
computing the first activation function of the second intermediate output such that the second intermediate output is restricted to a predefined range.

4. The processor implemented method as claimed in claim 2, wherein the first activation function is a sigmoid function.

5. The processor implemented method as claimed in claim 2, wherein the second activation function is a tangent hyperbolic function.

6. A system (100), comprising:

a memory (102) storing instructions;
one or more communication interfaces (106);
an In-Memory Computing (IMC) controller unit (108); and
one or more hardware processors (104) coupled to the memory (102) and the IMC controller (108) via the one or more communication interfaces (106),
wherein the one or more hardware processors (104) are configured by the instructions to:

map a specific GRU weight network parameter from a plurality of GRU weight network parameter to each of a memristor array structure of a Resistive Random-Access Memory In-Memory Computing-based gated recurrent unit (RRAM IMC-based GRU) network architecture in a skewed arrangement for being stored, wherein the RRAM IMC-based GRU network architecture comprises a first storage unit, a second storage unit, an In Memory Computing (IMC) controller unit, and a reduced instruction set computing (RISC-V) based core processing unit, wherein the second storge unit comprises a plurality of modules that includes a first set of IMC circuit modules, a second set of IMC circuit modules, an output specific IMC circuit module, an adder circuit module, and one or more biasing circuit modules, and wherein each IMC circuit module in the first set of IMC circuit modules and the second set of IMC circuit modules comprise a plurality of RRAM devices that are arranged as a plurality of memristor array structures, wherein each memristor array structure from the plurality of memristor array structures comprises a plurality of rows and a plurality of columns connected by a plurality of memristive cells, and wherein each GRU weight network parameter represents a conductance value;
input a multi-bit input vector to a plurality of rows of a first memristor array structure of the first set of IMC circuit modules that is mapped to a specific GRU weight network parameter and a past hidden state vector to the plurality of rows of a first memristor array structure of the second set of IMC circuit modules that is mapped to the corresponding specific GRU weight network parameter, wherein the multi-bit input vector and the past hidden state vector represent a voltage value;
concurrently perform a plurality of GRU operations on the RRAM IMC-based GRU network architecture using the multi-bit input vector, the plurality GRU weight network parameters, and the past hidden state vector for obtaining a plurality of IMC output values, wherein the plurality of GRU operations are concurrently performed till an end of the multi-bit input vector application and a last value of the past hidden state vector is applied to the RRAM IMC-based GRU network architecture, and wherein the plurality of GRU operations comprise at least one of (i) a multiply-accumulate (MAC) operation, (ii) an addition, (iii) a computation of one or more activation functions, and (iii) a computation of Hadamard products of the one or more activation functions and a corresponding output of a past GRU operation from the plurality of GRU operations, and wherein the in memory computing IMC output represents an accumulated bitline current value;

determine a digital value corresponding to each of the plurality of IMC output values using an analog-to-Digital Converter (ADC); and

determine a final output value for each of the plurality of IMC output values based on accumulation of the digital value corresponding to each of the plurality of IMC output values with one or more bias input values provided by the one or more biasing circuit modules using the adder circuit module.

7. The system as claimed in claim 6, wherein the step of concurrently performing plurality of GRU operations till the end of the multi-bit input vector application and the last value of the past hidden state vector is applied to the RRAM IMC-based GRU network architecture comprises:

performing the MAC operation for (i) the multi-bit input vector and the corresponding specific GRU weight network parameter mapped to the first memristor array structure of the first set of IMC circuit modules, and (ii) the past hidden state vector and the corresponding specific GRU weight network parameter mapped to the first memristor array structure of the second set of IMC circuit modules to obtain a first MAC output;

simultaneously computing (i) a second MAC output and (ii) a first activation function from the one or more activation functions using the first MAC output, wherein the second MAC output is computed by performing the MAC operation between the past hidden state vector and the corresponding specific GRU weight network parameter mapped to a second memristor array structure of the second set of IMC circuit modules;

simultaneously computing (i) a third MAC output and (ii) a Hadamard product of the first activation function and the second MAC output, wherein the third MAC output is computed by performing the MAC operation between the multi-bit input vector and the corresponding specific GRU weight network parameter mapped to a second memristor array structure of the first set of IMC circuit modules;

simultaneously computing (i) a fourth MAC output and (a) an accumulated Hadamard product of the first activation function, (b) the second MAC output, and (c) the third MAC output, wherein the fourth MAC output is computed by performing the MAC operation for (i) the multi-bit input vector and the corresponding specific GRU weight network parameter mapped to the third memristor array structure of the first set of IMC circuit modules, and (ii) the past hidden state vector and the corresponding specific GRU weight network parameter mapped to the third memristor array structure of the second set of IMC circuit modules;

computing the first activation function and a second activation function for the fourth MAC output to obtain a fifth MAC output and a sixth MAC output; and

obtain a first intermediate output by performing a subtraction operation and a Hadamard product of the fifth MAC output and the sixth MAC output.

8. The system as claimed in claim 7, wherein the step of concurrently performing plurality of GRU operations after the end of the multi-bit input vector application and the last value of the past hidden state vector is applied to the RRAM IMC-based GRU) network architecture comprises:

performing the MAC operation on (i) a current hidden state vector obtained from the first intermediate output and (ii) an output GRU weight parameter stored in the output specific IMC circuit module to obtain a second intermediate output; and

computing the first activation function of the second intermediate output such that the second intermediate output is restricted to a predefined range.

9. The system as claimed in claim 7, wherein the first activation function is a sigmoid function.

10. The system as claimed in claim 7, wherein the second activation function is a tangent hyperbolic function.

11. One or more non-transitory machine-readable information storage mediums comprising one or more instructions which when executed by one or more hardware processors cause:

mapping a specific GRU weight network parameter from a plurality of GRU weight network parameter to each of a memristor array structure of a Resistive Random-Access Memory In-Memory Computing-based gated recurrent unit (RRAM IMC-based GRU) network architecture in a skewed arrangement for being stored, wherein the RRAM IMC-based GRU network architecture comprises a first storage unit, a second storage unit, an In Memory Computing (IMC) controller unit, and a reduced instruction set computing (RISC-V) based core processing unit, wherein the second storge unit comprises a plurality of modules that includes a first set of IMC circuit modules, a second set of IMC circuit modules, an output specific IMC circuit module, an adder circuit module, and one or more biasing circuit modules, and wherein each IMC circuit module in the first set of IMC circuit modules and the second set of IMC circuit modules comprise a plurality of RRAM devices that are arranged as a plurality of memristor array structures, wherein each memristor array structure from the plurality of memristor array structures comprises a plurality of rows and a plurality of columns connected by a plurality of memristive cells, and wherein each GRU weight network parameter represents a conductance value;

inputting a multi-bit input vector to a plurality of rows of a first memristor array structure of the first set of IMC circuit modules that is mapped to a specific GRU weight network parameter and a past hidden state vector to the plurality of rows of a first memristor array structure of the second set of IMC circuit modules that is mapped to the corresponding specific GRU weight network parameter, wherein the multi-bit input vector and the past hidden state vector represent a voltage value;

concurrently performing a plurality of GRU operations on the RRAM IMC-based GRU network architecture using the multi-bit input vector, the plurality GRU weight network parameters, and the past hidden state vector for obtaining a plurality of IMC output values, wherein the plurality of GRU operations are concurrently performed till an end of the multi-bit input vector application and a last value of the past hidden state vector is applied to the RRAM IMC-based GRU network architecture, and wherein the plurality of GRU operations comprise at least one of (i) a multiply-accumulate (MAC) operation, (ii) an addition, (iii) a computation of one or more activation functions, and (iii) a computation of Hadamard products of the one or more activation functions and a corresponding output of a past GRU operation from the plurality of GRU operations, and wherein the in memory computing IMC output represents an accumulated bitline current value;

determining a digital value corresponding to each of the plurality of IMC output values using an analog-to-Digital Converter (ADC); and

determining a final output value for each of the plurality of IMC output values based on accumulation of the digital value corresponding to each of the plurality of IMC output values with one or more bias input values provided by the one or more biasing circuit modules using the adder circuit module.

12. The one or more non-transitory machine-readable information storage mediums as claimed in claim 11, wherein the step of concurrently performing plurality of GRU operations till the end of the multi-bit input vector application and the last value of the past hidden state vector is applied to the RRAM IMC-based GRU network architecture comprises:

performing the MAC operation for (i) the multi-bit input vector and the corresponding specific GRU weight network parameter mapped to the first memristor array structure of the first set of IMC circuit modules, and (ii) the past hidden state vector and the corresponding specific GRU weight network parameter mapped to the first memristor array structure of the second set of IMC circuit modules to obtain a first MAC output;

simultaneously computing (i) a second MAC output and (ii) a first activation function from the one or more activation functions using the first MAC output, wherein the second MAC output is computed by performing the MAC operation between the past hidden state vector and the corresponding specific GRU weight network parameter mapped to a second memristor array structure of the second set of IMC circuit modules;

simultaneously computing (i) a third MAC output and (ii) a Hadamard product of the first activation function and the second MAC output, wherein the third MAC output is computed by performing the MAC operation between the multi-bit input vector and the corresponding specific GRU weight network parameter mapped to a second memristor array structure of the first set of IMC circuit modules;

simultaneously computing (i) a fourth MAC output and (a) an accumulated Hadamard product of the first activation function, (b) the second MAC output, and (c) the third MAC output, wherein the fourth MAC output is computed by performing the MAC operation for (i) the multi-bit input vector and the corresponding specific GRU weight network parameter mapped to the third memristor array structure of the first set of IMC circuit modules, and (ii) the past hidden state vector and the corresponding specific GRU weight network parameter mapped to the third memristor array structure of the second set of IMC circuit modules;

computing the first activation function and a second activation function for the fourth MAC output to obtain a fifth MAC output and a sixth MAC output; and

obtain a first intermediate output by performing a subtraction operation and a Hadamard product of the fifth MAC output and the sixth MAC output.

13. The one or more non-transitory machine-readable information storage mediums as claimed in claim 12, wherein the step of concurrently performing plurality of GRU operations after the end of the multi-bit input vector application and the last value of the past hidden state vector is applied to the RRAM IMC-based GRU) network architecture comprises:

performing the MAC operation on (i) a current hidden state vector obtained from the first intermediate output and (ii) an output GRU weight parameter stored in the output specific IMC circuit module to obtain a second intermediate output; and

computing the first activation function of the second intermediate output such that the second intermediate output is restricted to a predefined range.

14. The one or more non-transitory machine-readable information storage mediums as claimed in claim 12, wherein the first activation function is a sigmoid function.

15. The one or more non-transitory machine-readable information storage mediums as claimed in claim 12, wherein the second activation function is a tangent hyperbolic function.

**FIG. 1**

Mapping a specific GRU weight network parameter from a plurality of GRU weight network parameter to each of a memristor array structure of a Resistive Random-Access Memory In-Memory Computing-based gated recurrent unit (RRAM IMC-based GRU) network architecture in a skewed arrangement for being stored, wherein the RRAM IMC-based GRU network architecture comprises a first storage unit, a second storage unit, an In Memory Computing (IMC) controller unit, and a reduced instruction set computing (RISC-V) based core processing unit, wherein the second storge unit comprises a plurality of modules that includes a first set of IMC circuit modules, a second set of IMC circuit modules, an output specific IMC circuit module, an adder circuit module, and one or more biasing circuit modules, and wherein each IMC circuit module in the first set of IMC circuit modules and the second set of IMC circuit modules comprise a plurality of RRAM devices that are arranged as a plurality of memristor array structures, wherein each memristor array structure from the plurality of memristor array structures comprises a plurality of rows and a plurality of columns connected by a plurality of memristive cells, and wherein each GRU weight network parameter represents a

$\sim$ 202

Inputting a multi-bit input vector to a plurality of rows of a first memristor array structure of the first set of IMC circuit modules that is mapped to a specific GRU weight network parameter and a past hidden state vector to the plurality of rows of a first memristor array structure of the second set of IMC circuit modules that is mapped to the corresponding specific GRU weight network parameter, wherein the multi-bit input vector and the past hidden state vector represent a voltage value

$\sim$ 204

A

**FIG. 2A**

A

Concurrently performing a plurality of GRU operations on the RRAM IMC-based GRU network architecture using the multi-bit input vector, the plurality GRU weight network parameters, and the past hidden state vector for obtaining a plurality of IMC output values, wherein the plurality of GRU operations are concurrently performed till an end of the multi-bit input vector application and a last value of the past hidden state vector is applied to the RRAM IMC-based GRU network architecture, and wherein the plurality of GRU operations comprise at least one of (i) a multiply–accumulate (MAC) operation, (ii) an addition, (iii) a computation of one or more activation functions, and (iii) a computation of Hadamard products of the one or more activation functions and a corresponding output of a past GRU operation from the plurality of GRU operations, and wherein the in memory computing IMC output represents an accumulated bit

206

Determining a digital value corresponding to each of the plurality of IMC output values using an analog-to-Digital Converter (ADC)

208

Determining a final output value for each of the plurality of IMC output values based on accumulation of the digital value corresponding to each of the plurality of IMC output values with one or more bias input values provided by the one or more biasing circuit modules using the adder circuit module

210

**FIG. 2B**

| | |
|---|---|
| RISC-V Based core processing unit | First storage unit <u>102a</u> (Main memory) |

Second storage unit <u>102b</u>

IMC Controller

First set of circuit Modules × $M$ ($16 \times N$)

Second set of circuit Modules × $K$ ($16 \times N$)

Digital Adder circuit module

Biasing circuit modules (Scratchpad memory)

Buffers + Input/Output Muxes

**FIG. 3**

Second storage unit 102b

| First set of IMC circuit modules (Tile 1) | Second set of IMC circuit modules (Tile 1) |

| Biasing circuit module | Adder circuit module (multi-bit digital adder) | Biasing circuit module |

Output specific IMC circuit module

**FIG. 4**

**FIG. 5A**

FIG. 5B

**FIG .6**

**FIG. 7**

EP 4 783 066 A1

FIG. 8

27

FIG. 9A

**FIG. 9B**

| 000 | 8CA | 000 |
|---|---|---|

$$+$$

| 000 | 1C2 | 000 |
|---|---|---|

$$=$$

| 0000 | 0A8C | 0000 |
|---|---|---|

**FIG. 9C**

**FIG. 9D**

| Europäisches Patentamt European Patent Office Office européen des brevets | **EUROPEAN SEARCH REPORT** | **Application Number** EP 25 20 3655 |

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LONG YUN ET AL: "ReRAM-Based Processing-in-Memory Architecture for Recurrent Neural Network Acceleration", IEEE TRANSACTIONS ON VERY LARGE SCALE INTEGRATION (VLSI) SYSTEMS, IEEE SERVICE CENTER, PISCATAWAY, NJ, USA, vol. 26, no. 12, 1 December 2018 (2018-12-01), pages 2781-2794, XP011702493, ISSN: 1063-8210, DOI: 10.1109/TVLSI.2018.2819190 [retrieved on 2018-11-30] | 1,6,11 | INV. G06N3/044 G06N3/048 G06N3/065 G11C13/00 G06F9/50 |
| A | * abstract; figures 2B, 4-7 * * Sections I, III * | 2-5, 7-10, 12-15 | |
| | ----- | | |
| A | HAN JIANHUI ET AL: "ERA-LSTM: An Efficient ReRAM-Based Architecture for Long Short-Term Memory", IEEE TRANSACTIONS ON PARALLEL AND DISTRIBUTED SYSTEMS, IEEE, USA, vol. 31, no. 6, 26 December 2019 (2019-12-26), pages 1328-1342, XP011768556, ISSN: 1045-9219, DOI: 10.1109/TPDS.2019.2962806 [retrieved on 2020-01-23] * abstract; figures 6, 8, 9 * * Sections 4-4.2.2 * | 1-15 | TECHNICAL FIELDS SEARCHED (IPC) G06N G11C G06F |
| | ----- | | |
| | -/-- | | |

The present search report has been drawn up for all claims

| Place of search | Date of completion of the search | Examiner |
|---|---|---|
| The Hague | 26 January 2026 | Houtgast, Ernst |

EPO FORM 1503 03.82 (P04C01)

Europäisches
Patentamt

European
Patent Office

Office européen
des brevets

**EUROPEAN SEARCH REPORT**

Application Number

EP 25 20 3655

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CHITHAMBARA MOORTHII J ET AL: "VPU-CIM: A 130nm, 33.98 TOPS/W RRAM based Compute-In-Memory Vector Co-Processor", 2024 IEEE INTERNATIONAL SYMPOSIUM ON CIRCUITS AND SYSTEMS (ISCAS), IEEE, 19 May 2024 (2024-05-19), pages 1-5, XP034628873, DOI: 10.1109/ISCAS58744.2024.10558155 [retrieved on 2024-07-02] * abstract; figure 1 * * Section II * ----- | 1-15 | |

TECHNICAL FIELDS
SEARCHED (IPC)

The present search report has been drawn up for all claims

| Place of search | Date of completion of the search | Examiner |
|---|---|---|
| The Hague | 26 January 2026 | Houtgast, Ernst |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202521006987